# EUROPÄISCHE PATENTSCHRIFT

(11) **EP 2 378 301 B1**
(45) Veröffentlichungstag und Bekanntmachung des Hinweises auf die Patenterteilung: **29.07.2020**
(21) Anmeldenummer: 11002534.3
(22) Anmeldetag: 28.03.2011
(51) Int. Cl.: G01R 31/59, G01R 35/00, G01R 31/12

(54) **Fehlersimulator für Leitungsisolations-Prüfgerät**
Faultsimulator for cable-isolation tester
Appareil de simulation de défaut pour testeur d'isolation de câble

(30) Priorität: 01.04.2010 DE 102010014387
(43) Veröffentlichungstag der Anmeldung: 19.10.2011
(73) Patentinhaber: SIKORA AG, 28307 Bremen (DE)
(72) Erfinder: Sikora Harald, 28357 Bremen (DE)
(74) Vertreter: Hauck Patentanwaltspartnerschaft mbB

(56) Entgegenhaltungen:
- EP-A1- 0 539 900
- DE-C- 975 957
- Ics 29: "Method for spark testing of cables", , 1. Juli 2002 (2002-07-01), Seiten 1-18, XP055176239, Gefunden im Internet: URL:http://www.dlqyw.net/ [gefunden am 2015-03-13]

## Beschreibung

Die Erfindung bezieht sich auf ein Verfahren zur Simulation von Fehlern bei Durchlaufspannungsprüfern nach Patentanspruch 1 und einen Durchlaufspannungsprüfer nach Patentanspruch 6.

Bekanntlich müssen Kabel und isolierte Leitungen eine vorgegebene Durchschlagsfestigkeit aufweisen. Für Kabel und isolierte Leitungen gibt es seit Langem Durchlaufspannungsprüfgeräte, die nach verschiedenen Normen die Isolierung von Leitungen mit Hilfe einer Testspannung auf Isolationsfehler testen. Hierzu gibt es auch seit Jahren eine europäische Norm EN 50356, die sowohl den Aufbau derartiger Geräte als auch die verschiedenen Testspannungen beschreibt und spezifiziert und darüber hinaus eine Anleitung bietet, wie die Empfindlichkeit bezüglich der Erkennung von Fehlstellen in der Isolation überprüft werden kann. Eine überarbeitete Version der europäischen Norm ist die EN 62230:2007. Bei dieser Norm wird von verschiedenen Testspannungsformen ausgegangen: Wechselspannungen von 40 bis 62 Hz, Wechselspannung mit annähernd sinusförmigem Verlauf und einer Frequenz zwischen 500 Hz und 1 MHz bzw. Impulsspannung mit einem schnellen Anstieg und stark gedämpftem Abfallen. Ein Durchlaufspannungsprüfer muss außerdem ein Anzeigesystem enthalten, dass optisch und/oder akustisch Fehler anzeigt, wenn die Isolierung oder der Mantel des Kabels aufgrund einer fehlerhaften Isolation oder Ummantelung der spezifizierten Testspannung nicht hält und ein Durchschlag zum geerdeten Leiter erfolgt. Der Fehlerdetektor muss einen digitalen Zähler so ansteuern, dass jeder diskrete Fehler gezählt wird. Er muss auch die Fehler summieren bis zum Ende des Kabeldurchlaufs. Der Zähler muss die Anzeige beibehalten, bis der nächste Fehler registriert oder die Anzeige manuell gelöscht wird.

Für die Empfindlichkeit des Durchlaufspannungsprüfers ist gefordert, dass der Fehleranzeiger anspricht, wenn ein künstlich erzeugter Fehler zwischen der Elektrode und der Erde geschaltet wird. Hierzu ist bekannt, einen sogenannten Fehlersimulator vorzusehen. Er ist so einzustellen, dass er für jeden simulierten Fehler eine Entladung in einer Funkenstrecke verursacht von einer Dauer von 0,025 Sekunden für Wechselspannung und Hochfrequenzspannung und von 0,0005 Sekunden für Gleichspannung. Es ist eine Folge von mindestens 20 derartiger Entladungen anzuregen, wobei diese zeitlich nicht mehr als eine Sekunde Abstand haben sollen. Die Empfindlichkeit des Fehlerdetektors ist so eingestellt, dass nicht mehr und nicht weniger als ein Zählimpuls je vorgesehener Entladung registriert wird.

Aus EP 0 539 900 A1 ist ein Durchlaufspannungsprüfer bekannt, welcher zwecks gleichmäßiger Bedeckung der Isolation eines zu untersuchenden Kabels Bürsten aus Carbonfasern aufweist und auch ausgedehnte blanke Stellen des Kabels detektieren kann. Die an die Carbonbürsten angelegte Prüfspannung wird mit einer Regelschaltung konstant gehalten.

DE 975 957 C beschreibt eine Vorrichtung zum Prüfen der Isolierung von elektrischen Leitern auf Durschlagfestigkeit, wobei die Prüfelektrode aus Metalldrahtbürsten besteht, welche den zu untersuchenden Leiter vollständig umhüllen.

Ein bekannter Fehlersimulator, mit dem die beschriebenen Anforderungen erfüllt werden, sieht eine von einem Elektromotor über ein Getriebe angetriebene Isolierscheibe vor, die eine Elektrode trägt, die permanent auf Erdpotential liegt. Ihr gegenüber ist eine stationäre Nadelelektrode angeordnet, die an die Testspannung gelegt wird. Der Abstand zwischen Nadelelektrode und Scheibenelektrode ist vorgegeben. Auch die Abmessungen der Nadelelektrode sind vorgegeben (Anhang B zu EN 62230:2007).

Der Betreiber einer Kabelproduktionsanlage, der ein Durchlaufspannungsprüfgerät verwendet, ist daher verpflichtet, mit Hilfe eines Simulators von Zeit zu Zeit das Gerät zu testen. Es ist empfohlen, die Beurteilung der Empfindlichkeit mindestens einmal im Jahr durchzuführen, sowie nach der ersten Installation und nach jeder Reparatur oder größeren Anpassung des Gerätes.

Der Erfindung liegt die Aufgabe zugrunde, ein Verfahren bzw. einen Durchlaufspannungsprüfer anzugeben, mit dem der Aufwand zur Prüfung auf Zuverlässigkeit erheblich verringert werden kann.

Diese Aufgabe wird durch Patentanspruch 1 bzw. Patentanspruch 6 gelöst.

Bei dem erfindungsgemäßen Verfahren nach Anspruch 1 wird die Hochspannung zum Testen der Empfindlichkeit des Fehlerdetektors an eine feststehende Standardfunkenstrecke vorgegebener Abmessung gelegt, und der Hochspannungsgenerator erzeugt in kurzen regelmäßigen Abständen eine Testspannung (Testhochspannung) von vorgegebener Höhe, Dauer und Häufigkeit. Richtet sich das Simulations- bzw. Testverfahren nach den Vorschriften der EU-Norm, dann betragen die Abstände zwischen den Zeitpunkten, in denen eine Testspannung an die Standardfunkenstrecke gelegt wird, höchstens eine Sekunde. Die Höchstdauer, in der Testspannung angelegt wird, beträgt 0,025 Sekunden bei Wechselstrom und Hochfrequenzspannung und 0,0005 Sekunden bei Gleichspannung. Die Anzahl der Aufschaltungen der Testspannung beträgt mindestens 20.

Bei der Erfindung wird statt einer mechanischen Beschaltung der künstlichen Funkenstrecke der Durchlaufprüfer selbst so gesteuert, dass die Testspannung normgemäß an eine feststehende Funkenstrecke gelegt wird. Durch die erfindungsgemäße Maßnahme lässt sich bei der künstlichen Funkenstrecke der Abstand zwischen der Spitze der Elektrode zur Gegenelektrode einmalig justieren. Er hängt nicht von irgendwelchen Toleranzen ab, wie sie z. B. bei der Rotation des bekannten Simulators entstehen. Der zusätzliche Aufwand, der erforderlich ist, einen Durchlaufspannungsprüfer mit einer erfindungsgemäßen Testfunktion auszurüsten, ist vernachlässigbar. Die in der EU-Norm aufgeführten Überprüfungsmaßnahmen bezüglich der Genauigkeit der Testspannung und der Einhaltung des maximalen Berührungsstroms lassen sich ebenfalls mit einem kleinen zusätzlichen Aufwand integrieren. Ein relativ aufwendiges separates Testgerät zur Überprüfung eines Durchlaufspannungsprüfers, wie es bisher eingesetzt wurde, entfällt somit. Bei der Erfindung ist der Fehler simulator zusammen mit einer zusätzlichen Testspannungs- und Kurzschlussstrommessung in das Durchlaufspannungsprüfgerät integriert.

Gemäß Anspruch 6 weist ein Durchlaufspannungsprüfer nach der Erfindung eine mit der Testspannung des Hochspannungsgenerators verbindbare Funkenstrecke mit Standardabmessungen auf sowie einen Taktgeber, der den Hochspannungsgenerator mit vorgegebener Frequenz und Häufigkeit einschaltet und nach einer vorgegebenen Zeitdauer jeweils wieder ausschaltet. Vorzugsweise ist im Hochspannungsgenerator eine Steuerung integriert, die nach einem gespeicherten Programm den Taktgeber steuert. Auf diese Weise kann ein Durchlaufspannungsprüfer sich selbst testen. Bei dem Betreiber einer Produktionsanlage entfällt ein gesondertes Testgerät.

Die Erfindung soll nachfolgend anhand von Zeichnungen näher erläutert werden.
- Fig. 1: zeigt schematisch einen Durchlaufspannungsprüfer bekannten Aufbaus.
- Fig. 2: zeigt schematisch einen bekannten Fehlersimulator z. B. für den Durchlaufspannungsprüfer nach Fig. 1.
- Fig. 3: zeigt ein Schaltbild für den Betrieb des Durchlaufspannungsprüfers nach der Erfindung.
- Fig. 4: zeigt verschiedene Diagramme für den Betrieb eines Fehlersimulators nach der Erfindung.
- Fig. 5: zeigt schematisch eine Funkenstrecke für einen Fehlersimulator nach der Erfindung.

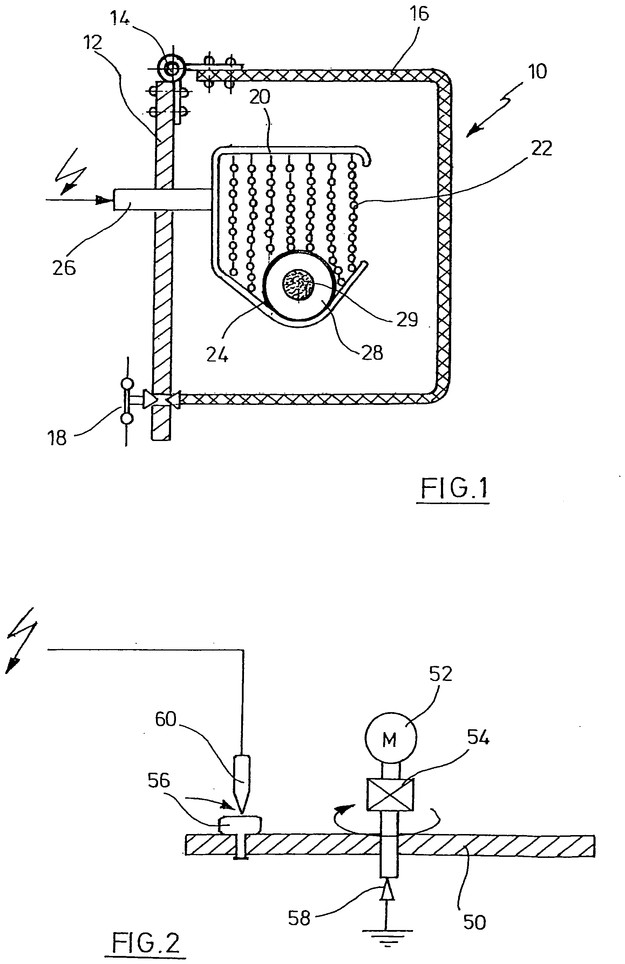

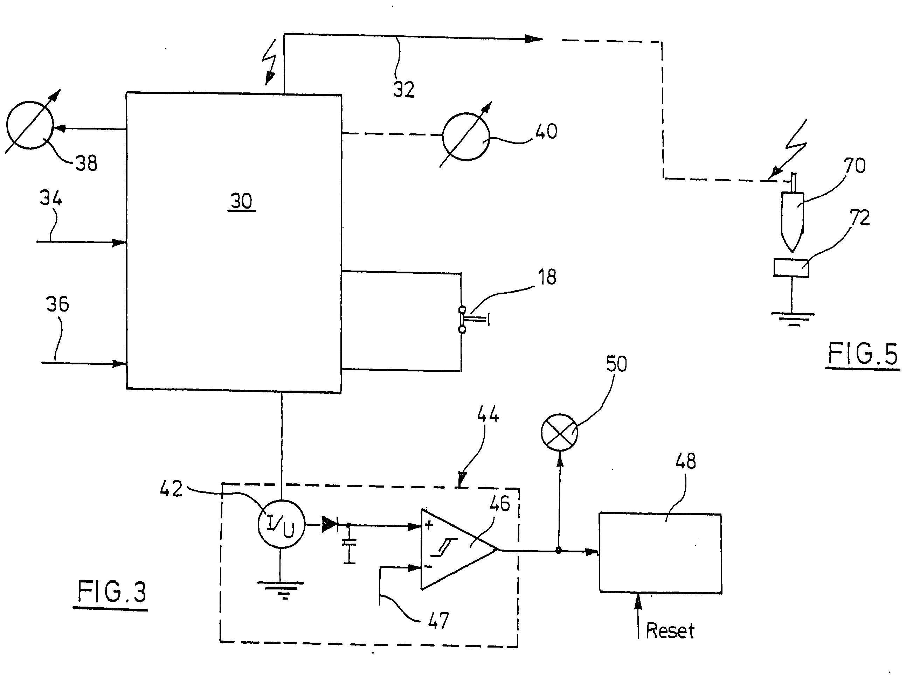

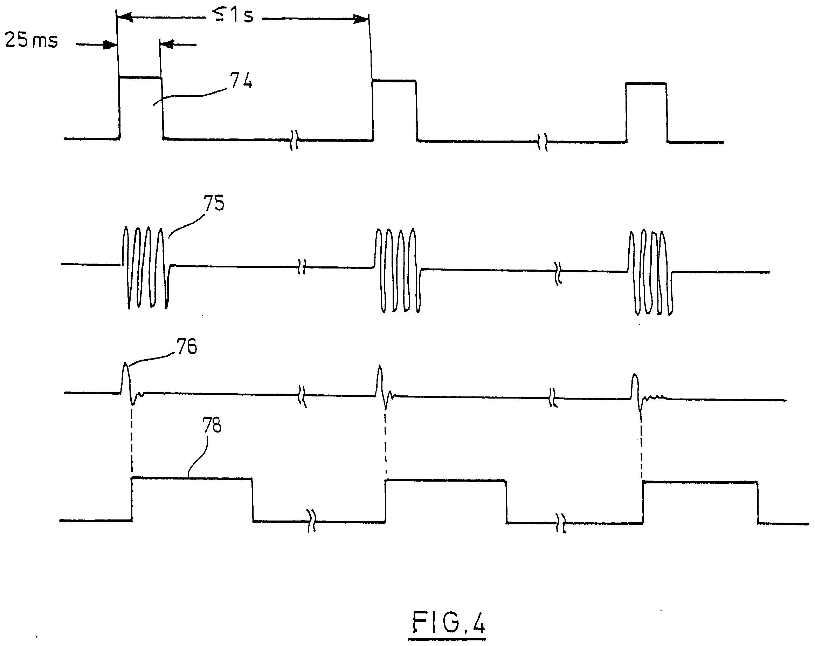

Ein an den Enden offenes Gehäuse 10 eines Durchlaufspannungsprüfers weist eine Isolierplatte 12 auf, an die über ein Scharnier 14 eine Haube 16 angelenkt ist. Ein bei 18 dargestellter Sicherheitsschalter öffnet bei Öffnung der Haube 16, damit beim Hineinfassen in die Haube keine Berührung mit Hochspannung erfolgt. Diese liegt nämlich als Testspannung an einer Prüfelektrode 20, an der eine Reihe paralleler Kugelketten 22 aufgehängt sind. Ein Kabel 24 bewegt sich in einer V-förmigen Vertiefung der Prüfelektrode 20 und durch den Vorhang aus den Kugelketten 22 hindurch. Die Prüfelektrode liegt, wie bei 26 dargestellt, an Testspannung. Der Leiter 29 des Kabels, dessen Isolation 28 geprüft werden soll, liegt auf Erdpotential. Fig. 3 zeigt schematisch die Schaltungsanordnung zum Betrieb des Durchlaufspannungsprüfers nach Fig. 1. Hierzu gehört eine Hochspannungsgenerator 30 mit einer Sicherheitsstrombegrenzung auf maximal 10 mA (maximal zulässiger Berührungsstrom). Seine Hochspannung wird bei 32 als Testspannung abgegeben, beispielsweise Gleichspannung, Wechselspannung oder Hochfrequenzspannung. Sie wird in Fig. 1 an die Elektrode 20 gelegt. Dem Hochspannungsgenerator 30 wird bei 34 eine Sollhochspannung vorgegeben. Eine Ansteuerung, wie bei 36 gezeigt, gestattet bei der erfindungsgemäßen Ausführung die Tastung der Testspannung 32 wie in Fig. 4, erste und zweite Zeile dargestellt. Bei 18 ist der Sicherheitsschalter gemäß Fig. 1 zu erkennen, der die Testspannung abschaltet, wenn die Haube 16 geöffnet wird.

Mit dem Hochspannungsgenerator 30 ist eine Anzeige 38 für den Istwert der jeweiligen Testspannung 32 verbunden. Bei 40 ist eine alternative Anzeige der Testspannung dargestellt, die in der erfindungsgemäßen Ausführung unabhängig von der Testspannungsanzeige 38 eine Überprüfung der Testspannung auf deren Einhaltung vorgegebener Toleranzen zulässt. Ein Stromspannungswandler 42 ist mit dem Generator 30 verbunden. Kommt es in der Isolation 28 zu einem Durchschlag, macht sich dies in einem signifikanten Absinken der Hochspannung und einem Anstieg des Stroms bemerkbar. Der Stromanstieg wird in einem Detektor 44, zu dem der Stromwandler 42 gehört, ermittelt. Über eine Gleichrichtung und einen Schwellwertschalter 46 gelangen diese Änderungen auf eine Fehlerzähler 48 sowie auf eine Fehleranzeige 50. Bei 47 lässt sich die Empfindlichkeit des Detektors einstellen.

Bis auf die erfindungsgemäßen Abweichungen ist ein Durchlaufspannungsprüfer mit den beschriebenen Merkmalen bekannt.

In Fig. 2 ist ein Fehlersimulator nach dem Stand der Technik dargestellt. Eine isolierende Scheibe 50 ist mit Hilfe eines Antriebsmotors 52 und eines Getriebes 54 um eine Hochachse drehend angetrieben. Eine erste Elektrode 56 befindet sich auf der Isolierscheibe 50 und ist, wie bei 58 dargestellt, permanent auf Erdpotential. Eine Nadelelektrode 60 als Gegenelektrode ist zu dem Kreis ausgerichtet, den die Plattenelektrode 56 bei Rotation der Scheibe 50 beschreibt. An die Elektrode 60 ist die Testspannung angelegt, und sobald sich die Elektrode 60 der Elektrode 56 gegenüberliegt, wird ein Funken erzeugt. Da die Testspannung an der Elektrode 60 vom Generator 30 stammt, wird auf diese Weise für den Detektor 44 nach Fig. 3 ein Fehler simuliert. Es kann daher festgestellt werden, ob der Detektor bestimmungsgemäß arbeitet, wenn der Fehlersimulator normgemäß betrieben wird, d. h. eine vorgegebene Drehzahl und Geschwindigkeit der rotierenden Isolierscheibe eingehalten wird sowie der Abstand der Elektroden 60, 56 voneinander und die Formgebung der Nadelelektrode 60 normgemäß sind.

In Fig. 5 ist eine Nadelelektrode 70 dargestellt, der eine Plattenelektrode 72 gegenüberliegt. Die Ausbildung der Elektroden 70, 72 entspricht derjenigen der Elektroden 56, 60 nach Fig. 2. Dies betrifft auch den Abstand der Elektroden 70, 72 voneinander. Beide Elektroden 70, 72 sind stationär. Mit Hilfe eines in Fig. 3 nicht dargestellten Taktgebers wird bei 36 die Testspannung des Generators 30 nach Fig. 3 ein- und ausgeschaltet. Im obersten Diagramm von Fig. 4 ist zu erkennen, dass im Abstand von höchstens einer Sekunde Einschaltimpulse 74 von einer Dauer von 25 ms erzeugt werden. Die gezeigte Testspannung liegt an der Elektrode 70 nach Fig. 5 an und erzeugt jeweils einen Funken. Falls die Funkenstrecke 70, 72 nicht an die Testspannung 32 des Generators 30 angelegt ist, ergeben sich Testspannungsverläufe 75, wie sie in dem zweiten Diagramm von Fig. 4 gezeigt sind. Man erkennt, dass während der Einschaltdauer 74 eine Wechselhochspannung erzeugt wird. Liegt hingegen die Funkenstrecke 70, 72 am Hochspannungsgenerator 30, ergeben sich Durchschläge, die Testspannung bricht zusammen auf die Bogenspannung der Funkenstrecke und es ergibt sich ein Verlauf der Testspannung 76, wie er im dritten Diagramm in Fig. 4 gezeigt ist. Die erkannten Durchschläge bewirken Fehlersignale, die vom Detektor 44 in Rechteckimpulse verwandelt werden, wie sie im letzten Diagramm von Fig. 4 zu erkennen sind. Die Fehlerimpulse werden auf den Fehlerzähler 48 bzw. die Fehleranzeige 50 gegeben. Es ist zu erkennen, dass durch gezieltes Ein- und Ausschalten des Hochspannungsgenerators und Anlegen daraus resultierender Testspannungen an die Funkenstrecke eine Fehlersimulation ermöglicht ist, welche eine Fehlersimulation gemäß Fig. 2 ersetzt. Die Ansteuerung des Testspannungsgenerators 30 kann für den geforderten Verlauf der Hochspannung Teil des Durchlaufspannungstesters sein, wenn dieser entsprechend modifiziert wird und erfordert kein separates Gerät, wie beim Fehlersimulator nach Fig. 2. Durch entsprechende Ansteuerung der Ein- und Ausschaltung des Hochspannungsgenerators 30, etwa nach einem vorgegebenen Programm, kann ein Selbsttest eines Durchlaufspannungsprüfers erfolgen. Es wird festgestellt, ob die vorgegebene Anzahl von simulierten Fehlern in vorgegebener Zeit auch die gleiche Anzahl von Fehlermeldungen auslöst, nicht mehr und nicht weniger.

Es versteht sich, dass während der Ansteuerung der Funkenstrecke nach Fig. 5 der normale Prüfbetrieb des Gerätes nach Fig. 1 unterbrochen ist. So kann ein - nicht gezeigter - Schalter vorgesehen werden, der den Hochspannungsgenerator 30 wahlweise mit der Prüfelektrode 20 oder der Funkenstrecke verbindet.

## Patentansprüche

1. Verfahren zur Simulation von Fehlerstellen bei Durchlaufspannungsprüfern, bei denen über eine Elektrode (20) eine Testspannung mit Hilfe eines Hochspannungsgenerators (30) an ein durchlaufendes Kabel (24) gelegt wird und Durchschläge von einem Detektor (44) erkannt und angezeigt und mittels eines Fehlerzählers (48) summiert werden, **dadurch gekennzeichnet, dass** mit einem in den Durchlaufspannungsprüfer integrierten Fehlersimulator die Testspannung für die Prüfung der Zuverlässigkeit der Erkennung von Fehlerstellen in vorgegebener Höhe, Dauer und Häufigkeit an eine feststehende Funkenstrecke (70, 72) gelegt wird und diese getasteten Testspannungen vom Hochspannungsgenerator (30) des Durchlaufspannungsprüfers erzeugt werden, wobei mit einer ebenfalls in das Durchlaufspannungsgerät integrierten zusätzlichen, unabhängigen Hochspannungsmessvorrichtung die Genauigkeit der eingestellten und angezeigten Testspannung überprüft wird und/oder wobei mit Hilfe einer ebenfalls in das Durchlaufspannungsgerät integrierten zusätzlichen, unabhängigen Messvorrichtung die Einhaltung des maximal zulässigen Berührungsstroms geprüft wird.

2. Verfahren nach Anspruch 1, **dadurch gekennzeichnet, dass** die Abstände der Testspannung eine Zeitdauer von weniger als 1 Sekunde haben.

3. Verfahren nach Anspruch 1 oder 2, **dadurch gekennzeichnet, dass** die Höchstdauer der Testspannungen 0,025 Sekunden bei Wechselspannung oder Hochfrequenzspannung oder 0,0005 Sekunden bei Gleichspannung beträgt.

4. Verfahren nach einem der Ansprüche 1 bis 3, **dadurch gekennzeichnet, dass** die Anzahl der Testspannungen mindestens 20 beträgt.

5. Verfahren nach einem der Ansprüche 1 bis 4, **dadurch gekennzeichnet, dass** die Prüfung auf Zuverlässigkeit der Erkennung von Fehlerstellen nach einem vorgegebenen Programm erfolgt, wobei festgestellt wird, ob die vorgegebene Anzahl von simulierten Fehlern in vorgegebener Zeit die gleiche Anzahl von Fehlermeldungen auslöst und zwar nicht mehr und nicht weniger und/oder die Genauigkeit der angezeigten Festspannung und/oder die Höhe der Berührungsspannung überprüft wird und ein Signal erzeugt wird, wenn die Zuverlässigkeitsprüfung positiv durchlaufen wird.

6. Durchlaufspannungsprüfer, umfassend einen Fehlersimulator mit einer an die Isolation (28) eines Kabels (24) oder einer Leitung anlegbaren Prüfelektrode (20), einem mit der Prüfelektrode (20) verbindbaren Hochspannungsgenerator (30), einem dem Hochspannungs-generator (30) zugeordneten Fehlerdetektor (44) und einem mit dem Fehlerdetektor (44) verbundenen Fehlerzähler (48), **dadurch gekennzeichnet, dass** der Fehlersimulator in den Durchlaufspannungsprüfer integriert ist, und dass eine mit dem Hochspannungsgenerator (30) verbindbare, feststehende Funkenstrecke (70, 72) vorgesehen ist und ein Taktgeber den Hochspannungsgenerator (30) so tastet, dass eine Testspannung von vorgegebener Höhe, Dauer und Häufigkeit erzeugt wird, wobei eine ebenfalls in das Durchlaufspannungsgerät integrierte zusätzliche, unabhängige Hochspannungsmessvorrichtung vorgesehen ist zum Überprüfen der Genauigkeit der eingestellten und angezeigten Testspannung und/oder wobei eine ebenfalls in das Durchlaufspannungsgerät integrierte zusätzliche, unabhängige Messvorrichtung vorgesehen ist zum Prüfen der Einhaltung des maximal zulässigen Berührungsstroms.

7. Durchlaufspannungsprüfer nach Anspruch 6, **dadurch gekennzeichnet, dass** in dem Hochspannungsgenerator (30) eine Steuerung integriert ist, die nach einem gespeicherten Programm den Taktgeber steuert.

## Claims

1. A method for simulating faults in spark testers in which a test voltage is applied via an electrode (20) with the assistance of a high voltage generator (30) to a continuous cable (24), and discharges are recognized and displayed by a detector (44) and totaled by means of a fault counter (48), **characterized in that** the test voltage for testing the reliability of recognizing faults at a given level, duration and frequency is applied to a fixed spark gap (70, 72) with a fault simulator integrated in the spark tester, and this generates sampled test voltages from the high voltage generator (30) of the spark tester, wherein the precision of the set and displayed test voltage is checked with an additional independent high voltage meter also integrated in the spark tester, and/or wherein the maintenance of the maximum permissible touch current is tested with the assistance of an additional independent measuring device also integrated in the spark tester.

2. The method according to 1, the spacings of the test voltage have a duration of less than one second.

3. The method according to claim 1 or 2, **characterized in that** the maximum duration of the test voltages is 0.025 seconds for alternating voltage or high frequency voltage, or 0.0005 seconds for direct voltage.

4. The method according to one of claims 1 to 3, **characterized in that** the number of test voltages is at least 20.

5. The method according to one of claims 1 to 4, **characterized in that** the test is for the reliability of recognizing faults according to a given program, wherein it is determined whether the given number of simulated faults within a given time triggers the same number of fault messages, namely neither more nor less, and/or the precision of the displayed fixed voltage and/or the level of the touch voltage is/are checked, and a signal is generated if the reliability test is successful.

6. A spark tester comprising a fault simulator with a test electrode (20) that can be applied to the insulation (28) of a cable (24) or a line, a high voltage generator (30) connectable to the test electrode (20), a fault detector (44) associated with the high voltage generator (30), and a fault counter (48) connected to the fault detector (44), **characterized in that** the fault simulator is integrated in the spark tester, and a fixed spark gap (70, 72) that can be connected to the high voltage generator (30) is provided, and a pulse generator samples the high voltage generator (30) so that a test voltage is generated with a given level, duration and frequency, wherein an additional, independent high voltage meter is provided that is also integrated in the spark tester for checking the precision of the set and displayed test voltage, and/or wherein an additional, independent measuring device that is also integrated in the spark tester is provided for testing the maintenance of the maximum permissible touch current.

7. A spark tester according to claim 6, **characterized in that** a control is integrated in the high voltage generator (30) which controls the pulse generator according to a saved program.

## Revendications

1. Procédé pour la simulation de défauts sur des testeurs de tension passante, dans lesquels une tension d'essai est appliquée à un câble traversant (24) par le biais d'une électrode (20) à l'aide d'un générateur de haute tension (30) et des claquages sont identifiés et indiqués par un détecteur (44) et totalisés au moyen d'un compteur de défauts (48), **caractérisé en ce que** la tension d'essai est appliquée avec un simulateur de défauts intégré dans le testeur de tension passante à un éclateur fixe (70, 72) selon une hauteur, une durée et une fréquence prédéfinies pour contrôler la fiabilité de l'identification de défauts, et ces tensions d'essai échantillonnées sont produites par le générateur de haute tension (30) du testeur de tension passante, dans lequel la précision de la tension d'essai réglée et indiquée est contrôlée avec un dispositif de mesure de haute tension indépendant supplémentaire également intégré dans l'appareil de tension passante et/ou dans lequel le respect du courant de contact maximal autorisé est contrôlé à l'aide d'un dispositif de mesure indépendant supplémentaire également intégré dans l'appareil de tension passante.

2. Procédé selon la revendication 1, **caractérisé en ce que** les intervalles de la tension d'essai présentent une durée inférieure à 1 seconde.

3. Procédé selon la revendication 1 ou 2, **caractérisé en ce que** la durée maximale des tensions d'essai s'élève à 0,025 seconde avec une tension alternative ou une tension haute fréquence ou à 0,0005 seconde avec une tension continue.

4. Procédé selon la revendication 1 à 3, **caractérisé en ce que** le nombre de tensions d'essai est d'au moins 20.

5. Procédé selon l'une des revendications 1 à 4, **caractérisé en ce que** le contrôle de la fiabilité de l'identification de défauts est effectuée selon un programme prédéfini, dans lequel il est constaté si le nombre prédéfini de défauts simulés déclenche le même nombre de messages de défaut en un temps prédéfini et notamment pas plus ni moins et/ou dans lequel la précision de la tension fixe indiquée et/ou la hauteur de la tension de contact est/sont contrôlée(s) et un signal est produit lorsque le contrôle de fiabilité s'est déroulé positivement.

6. Testeur de tension passante comportant un simulateur de défauts avec une électrode de test (20) apte à être appliquée à l'isolation (28) d'un câble (24) ou d'une ligne, un générateur de haute tension (30) apte à être relié à l'électrode de test (20), un détecteur de défauts (44) attribué au générateur de haute tension (30) et un compteur de défauts (48) relié au détecteur de défauts (44), **caractérisé en ce que** le simulateur de défauts est intégré dans le testeur de tension passante, et **en ce qu'**il est prévu un éclateur (70, 72) fixe apte à être relié au générateur de haute tension (30) et **en ce qu'**un générateur de cadence échantillonne le générateur de haute tension (30) de manière à produire une tension d'essai d'une hauteur, d'une durée et d'une fréquence prédéfinies, dans lequel il est prévu un dispositif de mesure de haute tension indépendant supplémentaire également intégré dans l'appareil de tension passante, pour contrôler la précision de la tension d'essai réglée et indiquée et/ou dans lequel il est prévu un dispositif de mesure indépendant supplémentaire également intégré dans l'appareil de tension passante, pour contrôler le respect du courant de contact maximal autorisé.

7. Testeur de tension passante selon la revendication 6, **caractérisé en ce qu'**une commande est intégrée dans le générateur de haute tension (30), laquelle commande le générateur de cadence selon un programme enregistré.
